# EUROPÄISCHE PATENTSCHRIFT

(11) **EP 1 348 257 B1**
(45) Veröffentlichungstag und Bekanntmachung des Hinweises auf die Patenterteilung: **22.07.2009**
(21) Anmeldenummer: 01986361.2
(22) Anmeldetag: 08.10.2001
(51) Int. Cl.: H03K 19/177

(54) **ZELLENANORDNUNG MIT SEGMENTIERTER ZWISCHENZELLSTRUKTUR**
DEVICE WITH SEGMENTED CELL STRUCTURE
DISPOSITIF A STRUCTURE EN CELLULES SEGMENTEE

(30) Priorität: 06.10.2000 US 238855 P; 09.10.2000 WO PCT/EP00/10516; 05.03.2001 DE 10110530; 07.03.2001 DE 10111014; 24.07.2001 DE 10135210; 24.07.2001 DE 10135211; 16.08.2001 DE 10139170; 29.08.2001 DE 10142231; 03.09.2001 DE 10142904; 03.09.2001 DE 10142894; 03.09.2001 DE 10142903; 11.09.2001 DE 10144733; 11.09.2001 DE 10144732; 17.09.2001 DE 10145792; 17.09.2001 DE 10145795; 19.09.2001 DE 10146132; 30.09.2001 WO PCT/EP01/11299
(43) Veröffentlichungstag der Anmeldung: 01.10.2003
(60) Teilanmeldung: 07006683.2
(73) Patentinhaber: PACT XPP Technologies AG, 80939 München (DE)
(72) Erfinder: VORBACH, Martin, 80689 München (DE); MAY, Frank, 81927 München (DE); REICHARDT, Dirk, 80807 München (DE); LIER, Frank, 81479 München (DE); EHLERS, Gerd, 85630 Grasbrunn (DE); NÜCKEL, Armin, 76777 Neupotz (DE); BAUGMARTE, Volker, 81677 München (DE); RAO, Prashant, 80335 München (DE); OERTEL, Jens, 76887 Bad Bergzabern (DE)
(74) Vertreter: Pietruk, Claus Peter
(86) Internationale Anmeldenummer: PCT/EP2001/011593
(87) Internationale Veröffentlichungsnummer: WO 2002/029600

(56) Entgegenhaltungen:
- US-A- 5 144 166
- US-A- 5 600 265
- US-A- 5 892 370

## Beschreibung

Die vorliegende Erfindung betrifft das oberbegrifflich Beanspruchte. Damit befaßt sich die vorliegende Erfindung mit Verbesserungen an Logikzellenarrays.

Logikzellenarrays, insbesondere auch rekonfigurierbare, sind bekannt. Zur Gattung dieser Bausteine zählen insbesondere systolische Arrays, neuronale Netze, Mehrpozessorsysteme, Prozessoren mit mehreren Rechenwerken und/oder logischen Zellen und/oder kommunikativen/peripheren Zellen (E/A, d.h. IO), Vernetzungs- und/oder Netzwerkbausteine wie z.B. Crossbar-Schalter, ebenso wie bekannte Bausteine der Gattung FPGA, DPGA, Xputer, Chameleon etc.. Hingewiesen wird in diesem Zusammenhang insbesondere auf die folgenden auf die vorliegenden Anmelder zurückgehenden Schutzrechte, die zu Offenbarungszwecken durch Bezugnahme vollumfänglich eingegliedert sind: DE 44 16 881, DE 197 81 412, DE 197 81 483, DE 196 54 846, DE 196 54 593, DE 197 04 044, DE 198 80 129, DE 198 61 088, DE 199 80 312, PCT/DE 00/01869, DE 100 36 627, DE 100 28 397 DE 101 10 530, DE 101 11 014, PCT/EP 00/10516, EP 01 102 674 sowie Familienmitglieder hierzu. Logikzellen sind somit definiert als beliebige Logik und/oder Arithmetik und/oder Schalter und/oder Speicher und/oder Peripherie beinhaltender Zellen.

Während für derartige Systeme im Stand der Technik, insbesondere dem vorstehend zitierten, eine Reihe von Ansätzen bekannt sind, um eine effiziente Verarbeitung von Daten prinzipiell zu ermöglichen, und diese Ansätze auch gut in Hardware-Architekturen implementierbar sind, besteht bei der praktischen Umsetzung dennoch der Wunsch, möglichst günstige Auslegungen zu gewährleisten, die insbesondere platzsparend auf einem Wafer untergebracht werden und/oder energiesparend betrieben werden können; überdies ist es wünschenswert, besonders vorteilhafte Arten des Betriebes zu finden.

Eine der gravierenden Schwierigkeiten bei Systemen aus dem Stand der Technik ist darin zu sehen, daß eine Vielzahl von Zellen miteinander kommunizieren müssen. Die Kommunikation kann erforderlich sein, um zu bearbeitende Daten zwischen den Zellen zu übermitteln. Dies ist etwa dann der Fall, wenn eine Zelle die Ergebnisse aus einer anderen Zelle weiterverarbeiten soll, z.B. durch Verknüpfung des dort erhaltenen Ergebnisses mit von einer oder mehreren weiteren Zellen erhaltenen Ergebnissen. Weiter kann Kommunikation erforderlich sein, um Statussignale zu übertragen.

Zur Übertragung von Signalen an einen einer Vielzahl möglicher Empfänger sind Busse seit langem bekannt. Busse sind Bündel aus Leitungen, wobei die Anzahl der Leitungen typisch bestimmt ist aus der Zahl miteinander , d.h. typisch parallel zu übertragender Bits, zuzügl. gegebenenfalls einer Reihe von Statusleitungen.

Bei bekannten einfachen Bussen, wie sie z.B. in PCs zur Kommunikation von Steckkarten mit der CPU und/oder untereinander verwendet werden, können die Bus-Leitungen zu allen Empfängern geführt werden und dann wird durch geeignete mitübertragene Steuersignale, d.h. Adressierung sichergestellt, daß nur diejenigen Empfänger ansprechen, die die Daten empfangen sollen. Problematisch wird eine solche Anordnung dann, wenn sehr viele kommunzierende Einheiten Zugriff auf den Bus bzw. die Busse benötigen. Es muß dann nämlich erforderlichenfalls mit der Kommunikation der Daten gewartet werden, bis der Bus von anderen Einheiten frei gegeben wurde und/oder es müssen Zeitscheibenlösungen implementiert werden, die einer sendenden Einheit nur eine bestimmte Übertragungszeit einräumen, und zwar im Regelfall unabhängig davon, ob in dieser Zeit alle Daten übertragen werden, was evtl. auch erforderlich macht, mehrere Zeitscheiben für die Datenübertragung aufzuwenden. Dieser Ansatz wird etwa in Systemen wie dem Token-Ring-Netzwerk praktiziert. In Systemen wie Logikzellenarrays, in denen eine sehr schnelle Kommunikation gewünscht ist, um hohe Datenverarbeitungsgeschwindigkeiten zu gewährleisten, ist dies unerwünscht.

Es ist auch schon vorgeschlagen worden, die Busse zu segmentieren. Wenn z.B. bei einer Reihe von Logikzellen mehrere miteinander zu verbindende Einheiten paarweise dicht beieinander liegen, kann eine längs aller Einheiten geführte und somit lange Busleitung an Zwischenstellen vermittels von Schaltern aufgetrennt werden, um so mehrere Teil-Busssysteme zu bilden. Jedes Segment umfaßt dabei wie der Gesamtbus die erforderliche Anzahl paralleler Daten-Leitungen und die zusätzlich notwendigen Protokollleitungen; die Kommunikation eines Paares dicht beieinander liegenden Logikzellen stört dann die Kommunikation eines anderen, dicht beieinander liegenden Paares nicht. So kann die über das Bussystem übertragene Datenrate wesentlich gesteigert werden.

Problematisch ist allerdings, daß, wenn derartige Bussystemen, etwa in CMOS-Technik auf Halbleiterchips integriert werden, der Aufbau typisch komplex und der Betrieb energetisch ungünstig ist.

Die Aufgabe der vorliegenden Erfindung besteht darin, Neues für die gewerbliche Anwendung bereitzustellen.

Die Lösung dieser Aufgabe wird in unabhängiger Form beansprucht. Bevorzugte Ausführungsformen finden sich in den Unteransprüchen.

Ein erster wesentlicher Aspekt der vorliegenden Erfindung schlägt somit vor, daß bei einer Logikzellenanordnung mit einer Anzahl Logikzellen und einem segmentierten Bussystem für die Logikzellenkommunikation, vorgesehen ist, daß das Bussystem unterschiedliche Segmentlinien mit kürzeren und längeren Segmenten zur Verbindung zweier Punkte umfaßt, um die Anzahl zu durchlaufender Buselemente bei auseinander beabstandeten Kommunikationsstart- und Endpunkten gering halten zu können.

Damit nutzt die vorliegende Erfindung in einem ersten Grundgedanken, daß sich durch Ausbildung der Busse mit als einfache Leitung gestalteten Segmenten großer Länge für die Überbrückung großer Strecken in einer Logikzellenanordung eine besonders einfache Ausgestaltung und ein besonders sparsamer Betrieb ergibt. Indem zugleich kurze Segmentlinien vorgesehen werden, ist sichergestellt, daß dennoch alle Punkte wie erforderlich ansprechbar sind.

Bevorzugt sind die Segmentlinien jeweils aus einer Mehrzahl paralleler Leitungen gebildet sind, deren Anzahl durch die Bus-Breite und/oder das Busprotokoll bestimmt ist. Es ist also jedes Segment durch ein Bündel paralleler Leitungen gebildet, so wie dies per se aus dem Stand der Technik bekannt ist. Es versteht sich, daß dann alle Leitungen eines Segmentes im wesentlichen die selben Längen aufweisen; im wesentlichen bedeutet dabei, daß die Leitungen eines Leitungsbündels alle zu ein und derselben Endpunktlinie wie einem Dateneingang einer Logikzelle geführt sein können, wo sie an die ihnen bitweise zugeordneten Eingangsglieder gelegt werden können.

Es ist bevorzugt, wenn an datenverändernde Logikzellen wie Recheneinheiten drei der für die verarbeitete Bitbreite erforderlichen Leitungsbündel als Datenzuführungsleitungen zugeführt sind. Dies erlaubt es, innerhalb der Zelle eine Verknüpfung von Operanden A, B, C der Art AxB+C vorzunehmen. Diese Operation ist im Bereich digitaler Signalverarbeitung von besonderer Bedeutung und die Busstruktur somit für Logikzellenarrays zum Aufbau echtzeitrekonfigurierbarer DSP-Arrays besonders geeignet.

Es ist insbesondere bei Logikzellenanordnung, mit denen eine arithmetisch-multiplikative Verknüpfung von Operanden vorgenommen werden kann, besonders bevorzugt, wenn aus den Zellen wenigstens zwei der für die verarbeitete Bitbreite erforderlichen Leitungsbündel für Daten weggeführt sind, insbesondere mit einem Leitungsbündel für höherwertige und einem Leitungsbündel für niederwertigere Bits; so kann bei einer Datenwortbreite von 32 Bit ein 64 Bit breiter Ausgang erzeugt werden, um das Ergebnis einer Multiplikation in voller Breite auszugeben.

Bei rekonfigurierbaren Logikzellen ist es bevorzugt, wenn insbesondere über das segmentierbare Bussystem Steuereingänge ansprechbar sind, die derart angeordnet sind, daß wenigstens die Steuersignale zur Ablaufsteuerung in der Logikzelle, wie z.B. die Signale Reset, Step, Stop, Go und Reload in die Zelle übertragbar sind. Mit diesen wird ausgelöst und/oder ermöglicht ein Zurücksetzen, eine Umkonfigurierung und eine Aktivierung. Dazu kann eine entsprechende Anzahl von Bitleitungen vorgesehen werden; bevorzugt werden daher wenigstens zwei Bit breite Datenleitungen für Steuersignaleingänge vorgesehen. Es ist besonders bevorzugt, wenn jedem der steuernden Signale ein separater Signaleingang zugeordnet ist; alternativ kann eine Eingangsverknüpfungschaltung auf einer mehreren Bit breiten Statusleitung für ein ordnungsgemäßes Ansprechen der Zelle sorgen.Diese Steuersignaleingänge sind insofern Steuersignaleingänge, als über sie die konfigfurations- und/oder Rekonfigurationssteuernden (Kontrollfluß-) Signale, insbesondere Triggersignale wie aus dem vorerwähnten Stand der Technik bekannt, an die Zelle geleitet werden können. Die eigentliche Kommunikation der Zelle mit der oder einer umkonfigurierenden Einheit wie einem Konfigurationsmänager (CT bzw. CM) kann dabei in per se bekannter Weise z.B. über das sog. Ready/Ack/Rej-Protokoll erfolgen, das eine Umkonfiguration der Zelle nur unter bestimmten Bedingungen erlaubt. Für die Einzelheiten dieser Protokolle wird auf die einleitend durch Bezugnahme vollumfänglich eingegliederten Schutzrechte des Anmelders und jedwede weiteren öffentlich zugänglichen Dokumente über die XPP/VPU-Architektur verwiesen.

Das Bussystem kann Segmente zur Verbindung der Logikzellen untereinander umfassen; dies ist der typische Fall und deshalb von besonderer Bedeutung, weil innerhalb des Logikzellenarrays ein besonders hoher und effizienter Datendurchsatz benötigt wird, ohne daß sich der Prozessorbaustein etwa durch hohe Verlustleistungen aufheizen soll. Hier ist die vorliegende Erfindung besonders effizient einsetzbar.

Alternativ und/oder zusätzlich kann das Bussystem an interne und/oder externe die Logikzellen konfigurierenden und/oder rekonfigurierenden Einheiten geführt sein; die Busse können insbesondere an einer Vielzahl von datenverarbeitenden und/oder speichernden Logikzellen vorbei zu einer oder mehreren solchen (re-) konfigurierenden Einheiten geführt sein, so daß entweder eine Kommunikation der Zellen untereinander und/oder mit der oder einer konfigurierend Einheit möglich ist. Es sei in diesem Zusammenhang erwähnt, daß prinzipiell ein simultanes Aussenden von Informationen an mehrere Empfänger möglich ist, etwa, um im Falle des Bootens alle Zellen gleichzeitig zurückzusetzen. Die Busstruktur kann dafür entsprechend ausgebildet sein.

Weiter ist es bevorzugt und möglich, wenn das Bussystem zu I/O-Schnittstellen und/oder zu externen Datenspeichern geführt ist. Es kann mit anderen Worten die Segmentierungsstruktur sowohl innerhalb als auch außerhalb des Logikzellenfeldes mit Gewinn genutzt werden.
I/O-Schnittstellen übertragen bausteininterne Bussysteme nach extern. Dabei werden beliebige Bussysteme ggf. zeitlich alternierend zur externen Aus- und/oder Eingabe geschaltet. Zusätzlich kann die Möglichkeit bestehen mehrere Bussysteme derart zusammenzufassen, dass diese aufeinander synchronisiert werden. Beispielsweise können je zwei Ausgabebussysteme oder ein Eingabebus und ein Ausgabebus zusammen synchronisiert werden.

In einer praktischen Ausführung des Bussystem sind eine Reihe von Leitungszwischenelemente vorgesehen; Leitung meint hierbei insbesondere einen Leiter erster Klasse, wie eine durchgehende Metalllinie in einem Halbleiterwafer. Leitungszwischenelemente meint solche Elemente, die zwischen je zwei einander zugeordneten Leitungen angeordnet sind. Bei den Leitungszwischenelemente kann es sich zum einen handeln um Verbindungs-Schalter, die insbesondere im Ansprechen auf Anforderungen von Logikzellen und/oder die Kommunikation derselben und/oder anderer Einheiten vorgebenden Kontrollmitteln; so kann der Schalter z.B. im Ansprechen auf eine Anforderung eines Konfigurationsmanagers, d.h. einer das Logikzellenfeld konfigurierenden Einheit geschlossen oder geöffnet sein oder werden. Dies erlaubt es insbesondere, wie bevorzugt, mit einem Compiler festzulegen, wie die Busstruktur aufgebaut werden soll; insbesondere kann der Compiler oder eine andere konfigurierenden oder kontrollierende Einheit festlegen, ob die Kommunikation zwischen zwei beabstandeten Zellen über Segmentlinien mit kürzeren oder längeren Segmenten erfolgen soll, und bei Vorhandensein mehrerer längerer Segmente kann überdies auch bevorzugt vorgegeben werden, über welche einer Vielzahl von Segmentlinien die Kommunikation erfolgen soll. Es kann damit der Leistungsverlust über die Schalter minimiert werden und/oder es kann eine optimale Anpassung der Datenbe- und/oder -verarbeitung an Signallaufzeiten längs der Busleitungen vorgesehen werden.

Die Leitungszwischenelemente können weiter und/oder alternativ Multiplexer umfassen, um ein Signal von einer Leitung an eine einer Reihe von Zielen wie Logikzellen und/oder weiterführenden Leitungen aufzuschalten und/oder, um es auf eine Vielzahl von Zielen insbesondere wählbare Ziele simultan zu speisen.

Weiter können als Leitungszwischenelemente Register vorgesehen sein. Diese erfüllen unterschiedliche Aufgaben. So können zunächst Daten auf dem Bus gehalten werden, bis ein Ziel bereit ist, diese abzurufen. Weiter kann bei Bussen, die sehr lang sind, vermieden werden, daß die Datenverarbeitung nur dann geordnet abläuft, wenn die bei langen Strecken langen Dauern bis zur Ankunft der Daten am Ziel (und gegebenenfalls dem Rücklauf der Empfangsbestätigung) berücksichtigt werden. Indem Daten in Registern zwischengehalten werden, erhöht sich zwar die Gesamtzeit (delay), bis ein Datenpaket über den Bus gelaufen ist, aber die Zwischenzeit bis zur ankunft der Daten (latency), in der das Array bzw. einzelne Zellen nicht sinnvoll genutzt werden können, sind verringert. Es sei darauf hingewiesen, daß hier wiederum ein Abwägen zwischen Latency und Delay erforderlich sein kann, wobei das Register z.B. nur unter vorbestimmten und/oder festgelegten Bedingungen wie sehr langer Busstrecke zugeschaltet wird. Es ist dann wünschenswert, wenn die Registerzuschaltung gesteuert wird, z.B. durch eine Kontrolleinheit oder ähnliches wie einen Konfigurationsmanager, der wiederum im Ansprechen auf compilergenerierte Befehle arbeiten kann. Weiter ist es sinnvoll, ein Register vorzusehen, um ein synchrones Ankommen von Bits unterschiedlicher Wertigkeit an einem Zielpunkt zu gewährleisten. Wenn Busse rückwärts geführt sind, also eine Verbindung von einem Zellausgang zum Eingang derselben Zelle vorsehen, ist es besonders bevorzugt, Register einzusetzen, weil so hochfrequente Rückkopplungen, die Bauteilzerstörend sein können, durch die registerbedingte Delayzeit vermieden werden können.

Register können jeweils oder teilweise in einer besonders bevorzugten Variante als addierendes und/oder multiplizierendes Register ausgebildet sein; bestimmte Verknüpfungen lassen sich problemfrei und mit geringem Schaltungsaufwand implementieren und so kann netto die Logikzellenstruktur durch Verlagerung einfacher Verknüpfungsaugfgaben entlastet werden. Insbesondere kann ein Register dazu ausgebildet sein, genau zwei Operanden algebraisch zu verknüpfen; bei Bussen zur Übertragung von Statussignalen, die den Status einer oder einer Reihe von Logikzellen signalisieren und/oder dessen Änderung auslösen, d.h. bei Bussen für sog. Triggervektoren, können die Register bevorzugt dazu ausgelegt sein, Boolsche Verknüpfungen und/oder Nachschautabellen, insbesondere veränderbare Nachschautabellen, zu implementieren.

Als weitere, bevorzugt gleichfalls wahlweise zuschaltbare Leitungszwischenelement können Leitungstreiber vorgesehen sein. Dies kann insbesondere für Multiplexanordnungen erfoderlich sein, die ein starkes Signalauffächern (fanout) vorsehen.

In einer besonders bevorzugten Variante der Erfindung ist es möglich, längs eines Datenübertragungspfades einen Wechsel von einer Segmentlinie mit längeren auf eine Segmentlinie mit kürzeren Segmenten und/oder umgekehrt vorzusehen. Dies erlaubt es, bei Kommunikation einer größeren Zahl von Zellen in dieselbe Richtung, d.h. längs der selben Busstruktur, durch entsprechende Kombination kurzer und langer Segmente etwa gleiche Signallaufzeiten auch dann vorzusehen, wenn Zwischenregister vorgesehen sind. Vergleichbar ist die Busstruktur dabei mit einer Straße, die Schnellspuren und Kriechspuren aufweist und an vorgegebenen Zwischenstellen einen Spurwechsel ermöglicht.

Bevorzugt ist es allgemein, wenn das Bussystem eine Vielzahl von parallelen Segmentlinien umfaßt, wobei mehrere parallele Segmentlinien mit längeren Segmenten vorgesehen sind. Die längeren Segmente der Segmentlinien mit längeren Segmenten brauchen nicht alle gleichlang sein; es kann eine Staffelung vorgesehen sein.

Bevorzugt ist es allgemein weiter, wenn bei einer größeren Anzahl von parallelen Segmentlinien die Segmentlinienenden und/oder Leitungszwischenelemente in den Segmentlinien in Busrichtung versetzt gegeneinander angeordnet sind. Typisch sind an den Segmentlinienenden bzw. -anfängen Leitungszwischenelemente wie Schalter, Register, Multiplexer und Treiber vorgesehen. Die hardwaretechnische Implementierung dieser Elemente erfordert nun erheblichen Raum, der gegenüber dem von den in Zwischenschichten anzuordnenden Leitungen beachtlich sein kann. Die bevorzugte versetzte Anordnung dieser Elemente sorgt nun dafür, daß nur Raum für Leitungszwischenelementanordnungen von z.B. zwei oder drei Segmentlinien erfoderlich ist, nicht jedoch für Leitungszwischenelementanordnungen aller vorhandenen Segmentlinien. Auch ist es mögöich, nicht bei allen Leitungszwischenelementanordnungen Treiber oder Register vorzusehen, sondern diese nur jedes n.-tes Segmentende vorzusehen.Bevorzugt ist jedoch dann, daß wenigstens drei Segmentlinien mit längeren Segmenten für wenigstens zwei Segmentlinien bei vorgegebenen Stellen Segmentlinienwechselkreise angeordnet werden, insbesondere Multiplexer, als Leitungszwischenelemente vorgesehen sind. So kann der gewünschte Segmentwechsel wie erforderlich gestaltet werden. Bevorzugt ist die Busstruktur einem Zopf aus einer Vielzahl sich immer wieder kreuzender Strähnen vergleichbar, wobei an den Strähnenkreuzungen ein Segmentwechsel erfolgen kann und Wechsel unter längs des Busses variiernden Segmentpaaren oder Segmentgruppen möglich sind. Es ist dann möglich und bevorzugt, daß die Segmentlinienwechselkreise für den Wechsel von einer ersten auf eine zweite Segmentlinie an einer ersten Stelle und die Segmentlinienwechselkreise für den Wechsel von einer zweiten auf eine dritte Segmentlinie an einer zweiten Stelle vorgesehen sind.

Neben dem nur paarweisen Wechsel wird bevorzugt auch die Möglichkeit geschaffen, an einer Stelle oder einer Vielzahl von Stellen unter mehreren Segmentlinien zu wählen, auf die gewechselt wird und/oder auf welche simultan Daten aufgegeben werden.

In einem weiteren Aspekt der vorliegenden Erfindung wird der Logikzellenanordnung die Kommunikation der Zellen in zwei Richtungen möglich. Bei Busanordnungen mit Leitungszwischenelementen wie Treibern und/oder Registern sind Laufrichtungen definiert; um die Kommunikation der Zellen in zwei Richtungen zu ermöglichen, sind daher bevorzugt getrennte Busanordnungen für entgegengesetzte Laufrichtungen vorgesehen. Wenigstens in einer Richtung können wiederum für wenigstens unterschiedliche, insbesondere wiederum allgemein parallel geführte Segmentlinien mit kürzeren und längeren Segmenten vorgesehen sind.

Bei getrennten Segmentlinien für beide Laufrichtungen ist bevorzugt für wenigstens eine Laufrichtung Register vorgesehen, bevorzugt ist dabei, wie vorstehend erläutert, das Register im rückwärtsgeführten Bussystem vorgesehen, d.h. jenem Bussystem, mit denen Signale von einem Elementausgang zu einem Elementeingang zurückgeführt werden können.

Es sei erwähnt, daß gemäß einem weiteren Aspekt der vorliegenden ein erstes Bussystem für die Übertragung zu bearbeitender Daten und ein zweites Bussystem für die Übertragung von Status- und/oder Kontroll-bzw. Steuerinformation vorgesehen sein kann; wiederum kann ein oder beide Bussysteme mit kurzen und langen Segmenten aufweisenden Segmentlinien gebildet sein und es können bevorzugt die jeweiligen Bussysteme bzw. Busanordnungen separat voneinander konfigurierbar, d.h. in ihrer Verschaltung festlegbar und/oder hinsichtlich der Operationen in verknüpfenden Registern bzw. der Ausgabe von Nachschautabellen bestimmbar sein.

Im Regelfall wird das Bussystem bevorzugt Einsatz finden bei einer Logikzellenanordnung, bei welcher eine Mehrzahl von Logikzellen in Reihe nebeneinander angeordnet sind; es sind dann die die längeren Segmente an wenigstens einer Logikzelle vorbeigeführt; umfaßt die Logikzellenanordnung noch mehr Logikzellen in einer Reihe, sind bevorzugt die längsten Segmente an mehr als einer Logikzelle vorbeigeführt.

Es sei darauf hingewiesen, daß bei wenigstens zweidimensionalen Logikfeldern, also wenigstens reihen- und spaltenweiser Anordnung von Logikzellen, in jeder Reihe und in jeder Spalte ein segmentiertes Bussystem vorgesehen sein kann, das die vorbeschriebene Struktur mit langen und kurzen Segmenten in parallelen Segmentlinien aufweist.

Die beschriebene Busstruktur ist vorteilhaft bei allen Anordnungen, bei welchen datenverarbeitende also LogikEinheiten miteinander verküpft werden sollen. Besondere Vorteile bieten sich aber, wenn die Logikzellen ausgewählt sind aus, umfassen und/oder bilden Rechenwerke, DPGAs, Kress-Arrays, systolische Prozessoren und RAW-Machines; digitale Signalprozessoren (DSPs), die mehr als ein Rechenwerk besitzen, konfigurierbare (programmierbare) Logikzellen oder andere Cores und/oder PAEs, ALU, Eingabe- / Ausgabefunktionen (I/O) und/oder Speichermanagementeinheiten (I/O), Speicher. Eine erfolgreiche Implementierung einer Busstruktur mit Segmentlinien mit kurzen und langen Segmenten ist die VPU / XPP-Prozessoreinheit des Anmelders.

Ein solcher Prozessor wird bevorzugt eine Vielzahl unterschiedlicher, in einem Array angeordneter kommunizierender Logikeinheiten aufweisen, wobei die Logikeinheiten wenigstens Speicher- und Datenveränderungseinheiten aufweisen und die Speichereinheiten randnah am Array angeordnet sind. Dies erlaubt es, Daten durch das Array laufen zu lassen und am Rand erforderlichenfalls zwischenzuspeichern, um eine Umkonfigration wie erforderlich zu bewirken. Das Durchlaufen kann auch durch parallele Reihen oder Spalten erfolgen und/oder auf mäandernde Weise, um so erhöhte Rechenleistung bereitzustellen.

Auch können allenfalls Eingang/Ausgangseinheiten näher am Rand als die Speichereinheiten angeordnet sein; dies erlaubt die Zwischenspeicherung von Daten vor Verarbeitung unter Arraydurchlauf. In jedem Fall wird aber bevorzugt, wenn zur Kommunikation der Logikeinheiten wenigstens von Rand zu Rand wenigstens ein Bussystem vorgesehen ist, das insbesondere segmentierbar ist wie vorbeschrieben. Dann ist es möglich, wenn zum Betrieb eines Prozessors Daten aus einem ersten randnahen Speicher ausgelesen und in einer erste, diesem Rand nahe Datenveränderungseinheit wie erforderlich verändert werden, von dort in wenigstens eine weitere Datenveränderungseinheit übertragen werden, um weitere Datenveränderungen wie erforderlich vorzunehmen, die Daten nach Durchlaufen mehrerer Datenveränderungseinheiten in einen zweiten randnahen Speichern an einer vom ersten Speicher entfernten Stelle eingespeichert werden, eine Umkofigurierung der Datenveränderungseinheiten zur Neubestimmung der Datenveränderung vorgenommen wird und die Daten ggf. in entgegengesetzer Laufrichtung durch zumindest einen Teil der Datenveränderungseinheiten geführt werden. Auch kann dann zum Betrieb vorgesehen sein, daß der Hinlauf in einer Reihe erfolgt und der Rücklauf in der bzw. einer darunter liegenden Reihe, um so Pipelineeffekte zu berücksichtigen.

Der Prozessor kann wenigstens ein programierbares Gatterfeld (PGA) und mehrere Datenveränderungseinheiten mit ALUs aufweisen, wobei anwendungsspezifisch bevorzugt sein kann, wenn wenigstens eine oder mehrere PGAs von anderen Datenveränderungseinheiten, insbesondere ALUs umgeben sind, um von diesen leicht Daten zu Verknüpfungszwecke erhalten und/oder an diese ausgeben zu können.

Es ist möglich, daß bei einem Array aus rekonfigurierbaren Einheiten mehrere miteinander in Kommunikation bringbare insbesondere identische (Teil-) Arrays vorgesehen sind. Hierzu kann jeweils eine Umkonfigurierungseinheit vorgesehen sein, die zur Umkonfiguration der umkonfigurierbaren Elemente des Arrays ausgebildet sein kann. Innerhalb des Arrays verlaufen dann die entsprechend vorstehend beschriebenen Busstrukturen. Es ist damit jedem Array eine Umkonfigurierungsverwaltungseinheit zugeordnet ist, die insbesondere an einer Arrayseite angeordnet sein kann, an welcher keine Speicher- und/oder I/O-Einheiten vorgesehen sind, wobei sich die Umkonfigurierung seinheit bevorzugt über die Breite des Arrays erstreckt, was den Vorteil bietet, daß eine optimale Chipform erzeugt werden kann.

Es ist dann wahlweise eine den Arrays gemeinsame Umkonfigurierungsverwaltungsübereinheit vorgesehen, die sich insbesondere über die Breite von mehr als einem Array erstreckt und die für die Kommunikation mit zumindest mehreren, bevorzugt allen der Umkonfigurierungsüberienheiten ausgelegt ist.

Alternativ und/oder zusätzlich ist es möglich, bei einem solchen Prozessor mit miteinander in Kommunikation bringbaren, insbesondere identischen Arrays, die umkonfigurierbare Datenveränderungseinheiten aufweisen, zwischen den Arrays Vermittlungseinheiten (VPAEs) vorzusehen sind, die zur Kommunikationsvermittlung unter den Feldern angeordnet sind.

Über solche Vermittlungseinheiten (VPAEs) könenn Daten und/oder Steuersignale (Kontrollsignale, Triggervektoren usw.) übertragen werden.

Es ist möglich, daß die Konfigurationseinheiten von wenigstens zwei der Arrays direkt in Verbindung miteinander stehen. Es kann dadurch auf eine überwachende (supervising) Konfigurationseinheit verzichtet werden und/oder eine Ausfallsicherheit erhöht werden. Bevorzugt wird dazu die Kommunikation der Konfigurationseinheiten der wenigstens zwei Arrays, die direkt in Verbindung miteinander stehen, über dedizierte Festleitungen und/oder über beim Booten vorkonfigurierte d.h. festgelegte Datenleitungen bestimmt.

Es sei erwähnt, daß eine mögliche und bevorzugte Ausbildung der Vermittlungseinheiten (VPAEs) darin besteht, daß diese zwei Konfigurationsregister aufweisen, wobei das erste Konfigurationsregister vom ersten Array und das zweite Konfigurationsregister vom zweiten Array ansprechbar ist. Nur wenn für beide Arrays der Zugriff auf die Vermittlungseinheiten zugelasen wurde, werden demnach Daten übertragen. Dazu kann das erste Array das Einstellen von Daten in die Vermittlungseinheiten durch entsprechende Konfigurierung des ersten Konfigurationsregisters zulassen und das Einstellen der Daten der anderen Konfigurationseinheiten über die dedizierte Leitung signalisieren. Danach sind die Daten abholbar, was durch Konfigurierung des zweiten Konfigurationsregisters bestimmbar ist. Insgesamt wird so ein schleusenartiges Übertragen von Daten durch die VPAEs ermöglicht. Die Trennung eines größeren Arrays in Teilarays erlaubt im übrigen insgesamt die Verringerung des von-einer Konfigurationseinheit handzuhabenden Konfigurationsaufwandes und kann dadurch zu einem effizienten Arraybetrieb beitragen, der nicht durch einen Konfigurationseinheit bedingten Engpass beeinträchtigt ist.

Es ist einleuchtenderweise bevorzugt, wenn die Teil-Arrays über eine mehrere Datenveränderungs- und/oder - transfereinheiten (VPAE) miteinander in Komunikation bringbar sind, um so auch hier keine Datenratenbeschränkung bei der Datenverarbeitung zu erzeugen.

Bevorzugt ist es, in der geometrischen Hardware-Implementierung der beschriebenen Anordung, wenn die kommunikationsermöglichenden Datenveränderungseinheiten beidseits über längs des Arrays verlaufende Busse an das Array verbindbar sind, wobei die Busse insbesondere über den Arrayrand hinauslaufend ausgebildet und dort insbesondere weiter zu I/O-Schnittstelleneinheiten führbar sein können.

Wie vorstehend erläutert, ist es besonders bevorzugt, wenn im Prozessor ein oder mehrere Datenweiterleitungsregelimplementierungsmittel, insbesondere eine Nachschautabelle vorgesehen ist/sind, das zur Ermöglichung der Datenweiterleitung und insbesondere Datenübersetzung im Ansprechen auf die gemeinsame Erfüllung einer Vielzahl von Kriterien, insbesondere ereignisbezogener Kriterien ausgebildet ist. Bei den Weiterzuleitenden Daten kann es sich insbesondere um Daten bzw. Triggervektoren handeln, die mit der Umkonfigurierung und/oder Umkonfigurierbarkeit von Logikzellen zu tun haben. Die Funktion bzw. die Übersetzung des jeweiligen Datenweiterleitungsregelimplementierungsmittel wird entsprechend konfiguriert.

Es ist möglich, den Prozessor auch und gerade mit segmentierten Busstrukturen so aufzubauen, daß Datenveränderungseinheiten und Datenspeichermittel vorgesehen sind, wobei zumindest einigen der Datenveränderungseinheiten Datenspeichermittel lokal zugeordnet sind, und insbesondere Mittel vorgesehen sind, um in die lokalen Datenspeichermittel lokal eingeschriebene Daten zur lokalen neuerlichen Datenveränderung lokal auszulesen. Mit anderen Worten können in einer Logikzelle Zwischenergebnisse gespeichert werden und mit anderen Daten und/oder unter Verwendung anderer Verknüpfungen weiterverarbeitet werden.

Wenn eine Umkonfigurierung eines Zellarrays aus im Betrieb rekonfigurierbaren Logikzellen erfolgt, das insbesondere eine Umkonfigurierung im Ansprechen auf die Propagation bestimmter vorgegebener Daten erlaubt, wie dies in der die Wave-Rekonfiguration beschreibenden und unter Bezug genommen Veröffentlichungen insbesondere Schutzrechtsanmeldungen des vorliegenden Anmelders tun, so ist besonders bevorzugt, wenn auswählbar ist, ob die Rekonfiguration im Ansprechen auf die Datenpropagation für alle Logikzellen erfolgt, die von den vorgegebenen und/oder daraus hergeleiteten Daten angeströmt werden und/oder nur für einen Teil, insbesondere einen Verarbeitungszweig (zB einen if-then-Zweig), während wenigstens ein anderer Zweig unverändert bleibt, was den Umkonfigurationsaufwand verringert und/oder nur eine Teilkette einer längeren Reihe von insbesondere nacheinander Daten verarbeitenden Logikzellen insbesondere bis zu einer vorgegebenen Logikzelle umkonfiguriert wird, und/oder, um die Rekonfiguration sofort oder nach der bzw. einer weiteren Datenverarbeitung zu gestatten. Dies erhöht den praktischen Nutzen der Wave-Rekonfiguration wesentlich. Es sei erwähnt, daß eine solche selektive Wave-Umkonfigurierung unter Verwendung von nur wenigen Befehlen möglich ist, insbesondere z.B. den Befehlen Reset, Step, Stop, Go, Reload. Dementsprechend kann die Anzahl der an eine umkonfigurierbare Logikzelle wie eine PAE geführter Trigger- bzw. Steuereingänge gering sein.

Es sei als besonders vorteilhaft und bevorzugt erwähnt, daß die Art und Weise, wie eine Logikzelle auf ein bestimmtes charakteristisches Datenpaket bei Wave-Rekonfiguration reagiert, vorladbar sein kann und/oder ist. Das kann insbesondeere durch Vorladen der Nachschautabellen geschehen, die in den Bussen vorgesehen sind. Die Busse können dabei zum Teil durch Logikzellen geführt sein und/oder von und/oder mit diesen gebildet sein.

Es ist ohne weiteres möglich, die Prozessoranordnung mit dem Bussystem der vorliegenden Erfindung zu nutzen, um bei Berechnungen das Verhalten nichtlinearer Systeme schnell und einfach zu approximieren. Dies geschieht bevorzugt, indem für eine Reihe aneinander angrenzender Arbeitsbereiche jeweilige geeignete Approximationen bestimmt werden, zu einem augenblicklichen Arbeitsbereich (n) sowie zu dessen unten und oben ((n-1), (n+1)) angrenzenden Arbeitsbereichen die Approximationen ermöglichenden Parameter vorgeladen werden, das Verhalten mit dem mittleren (n) Arbeitsbereich approximiert wird, bis der Arbeitsbereich, innerhalb dessen die Approximation geeignet ist, überschritten wird, dann mit jener der Approximation (n-1) weiter gearbeitet wird, welche zu dem Arbeitsbereich gehört, in welchen hinein die Überschreitung erfolgte und bevorzugt die Approximation zu jenem Arbeitsbereich (n+1), in welchen hinein die Überschreitung nicht erfolgte, überschrieben wird mit einer Approximation (n-2), die gemeinsam mit der zuvor verwendeten Approximation (n) die derzeit verwendete Approximation (n-1) bzw. die zugehörigen Arbeitsbereiche umklammert. Durch das Überschreiben jenes Arbeitsbereichs, in welchen der Arbeitswert nicht gelaufen ist, brauchen bei eindimensionalen Fällen nur drei Varianten vorgeladen zu sein, um eine schnelle Weiterverarbeitung nach Bereichsüberschreitung zu sichern. Da das Überschreiben des vorgeladenen Arbeitsbereiches während der Datenverarbeitugn geschieht, ist bei stetigem Übergang der Arbeits-Werte ohne größere Sprünge oder steile Änderungen eine konstante Datenberechnung möglich. Es sei als einleuchtend erwähnt, daß sich diese Art der Approximation auf mehrdimensionale Fälle durch Arbeitswertumklammerung in mehr als einer Richtung und entsprechendes Überschreiben der nach Überschreiten eines n-dimensionalen Arbeitswertintervalls nicht mehr dem aktuellen Arbeitswertintervall benachbarter Intervalle übertragen läßt und schutzrechtlich als umfaßt angesehen wird.

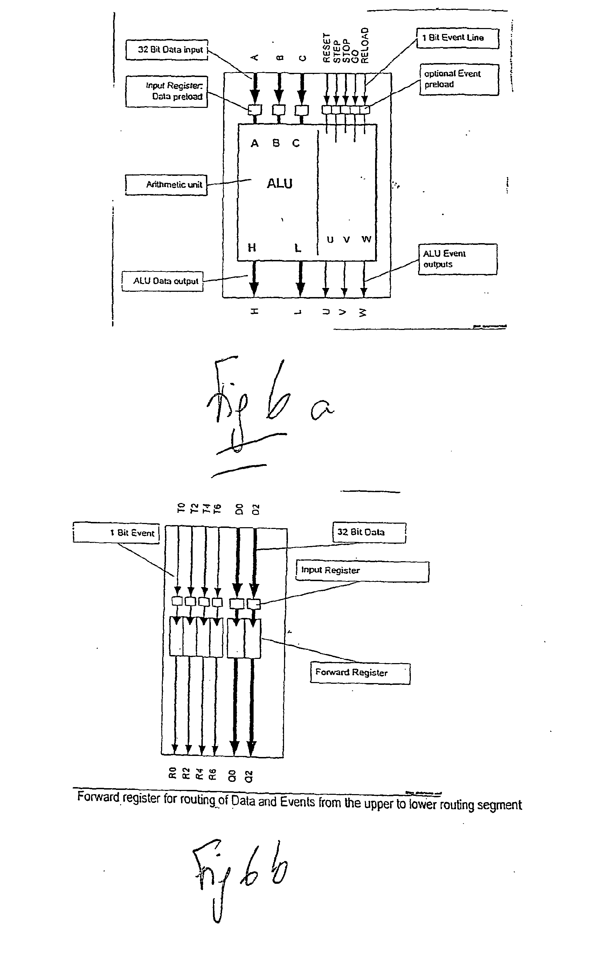

Die Erfindung wird im Folgenden nur beispielsweise anhand der Zeichnung beschrieben. In dieser zeigt:
Fig.1 den Gesamtaufbau eines erfindungsgemäß ausgestalteten Logikzellenarrays

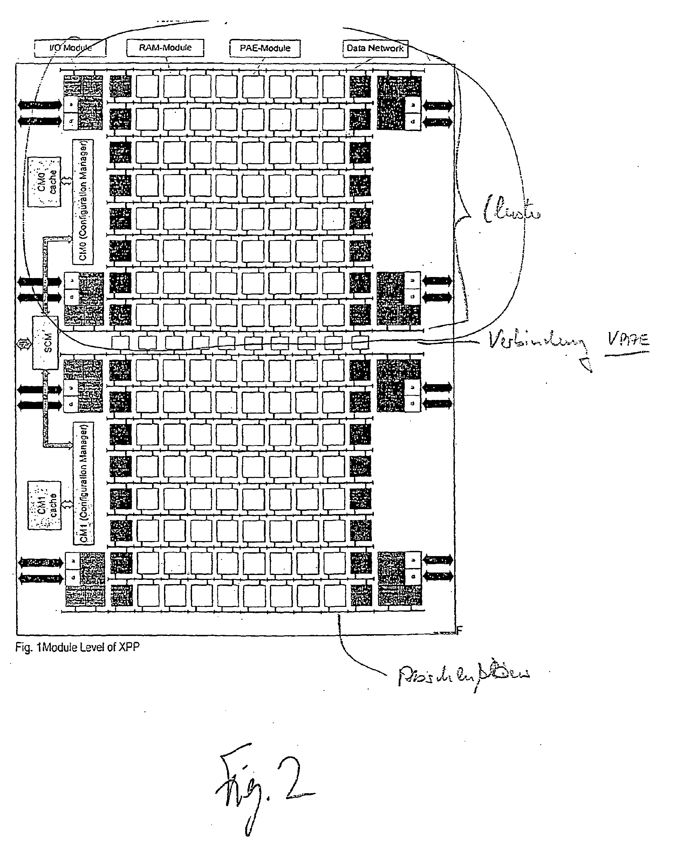

Fig.2 eine detailliertere Ansicht hierzu mit als Clustern bezeichneten Teilarrays, VPAEs dazwischen und Anschlußbussen

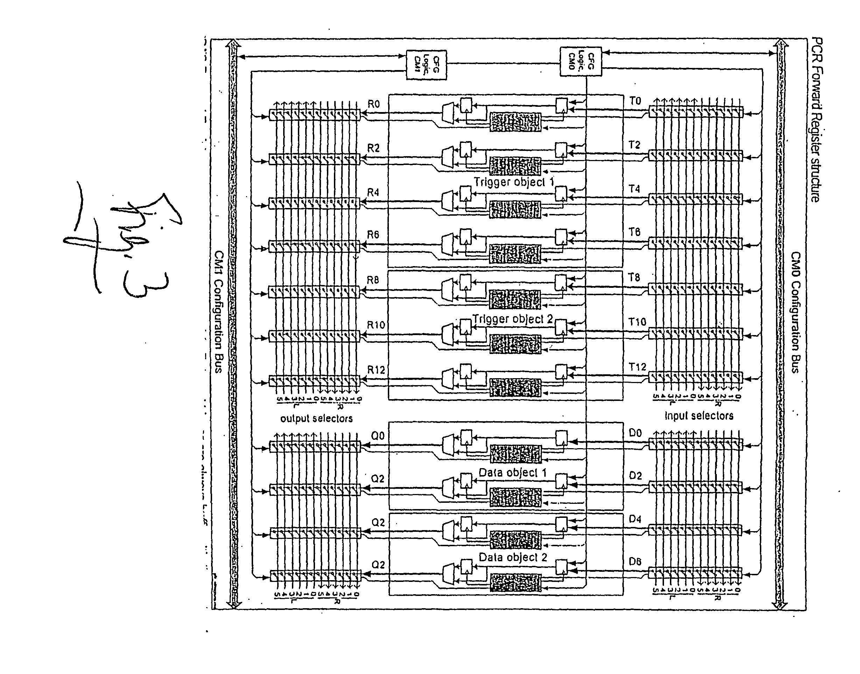

Fig. 3 ein Beispiel für ein Vorwärtsregister eines Konfigurationsbusses

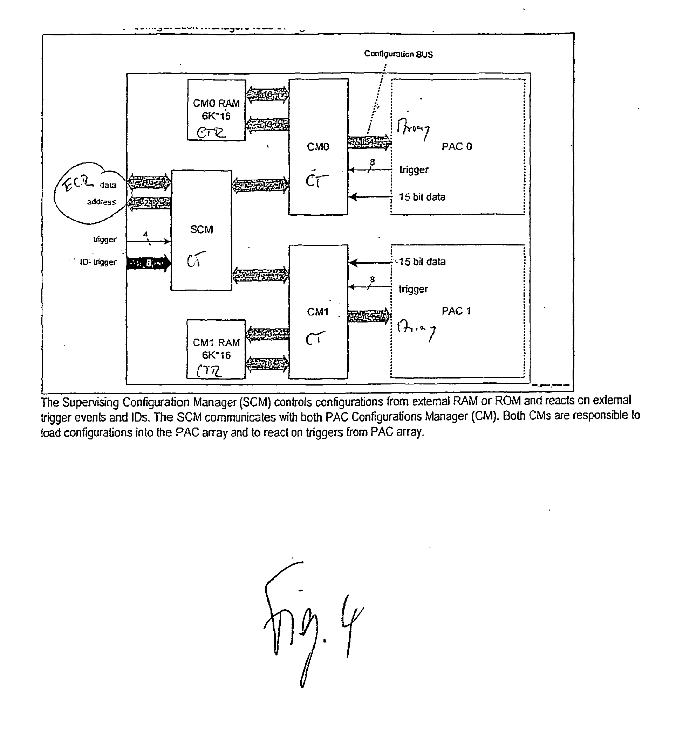

Fig. 4 die Hierarchie von Konfigurationsmanagern eines erfindungsgemäß ausgestalteten Logikzellenarrays
Fig. 5 Details einer PAE mit Angaben, welche Details in verschiedenen Voranmeldungen partiell zu entnehmen sind. Erkennbar sind die drei Dateeingänge A B C in die Logikzelle, die fünf Triggereingänge für den Triggervektor Reset Stop Step GO RELoad, die beiden Daten-Ausgänge H(igh) und L(ow) sowie die Statussignalausgänge UVW und ie Busaufkopplung
Fig .6 a den Aufbau der Logikzelle im Blockbild
Fig. 6b den Aufbau eines Registers

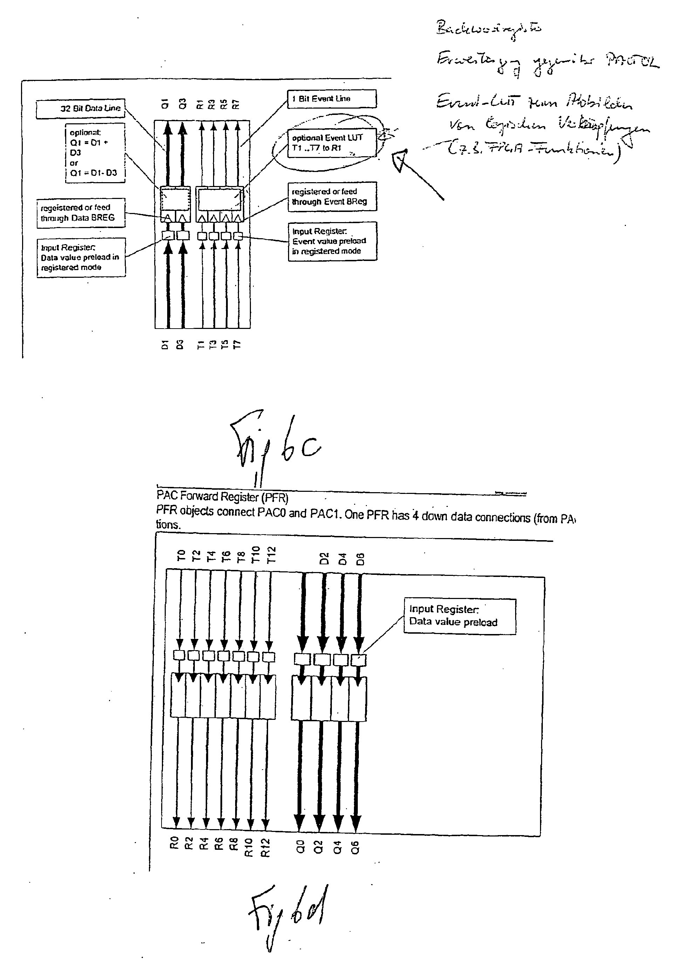

Fig. 6c den Registeraufbau eiens Rückwärtsregisters für Eventsignale mit der hier neuen optionalen Nachschautabelle
Fig. 6d ein Vorwärtsregister mit Vorlademöglichkeit

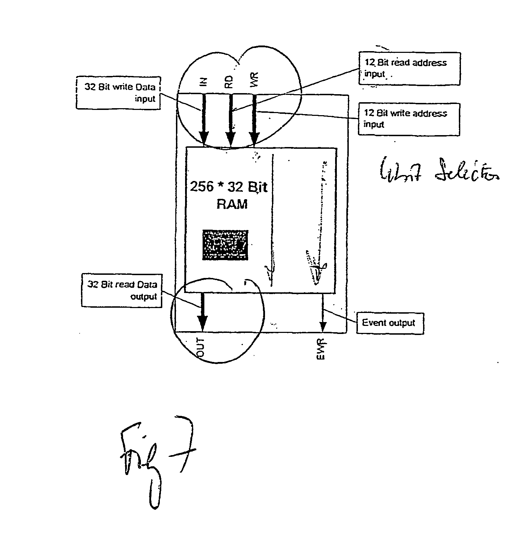

Fig 7 den Detailaufbau einer Speicherzelle, die eine von datenverändernden Logikzellen (PAEs) unterschiedlichen Eingang mit entsprechender anderer erforderlicher Busbreite aufweist

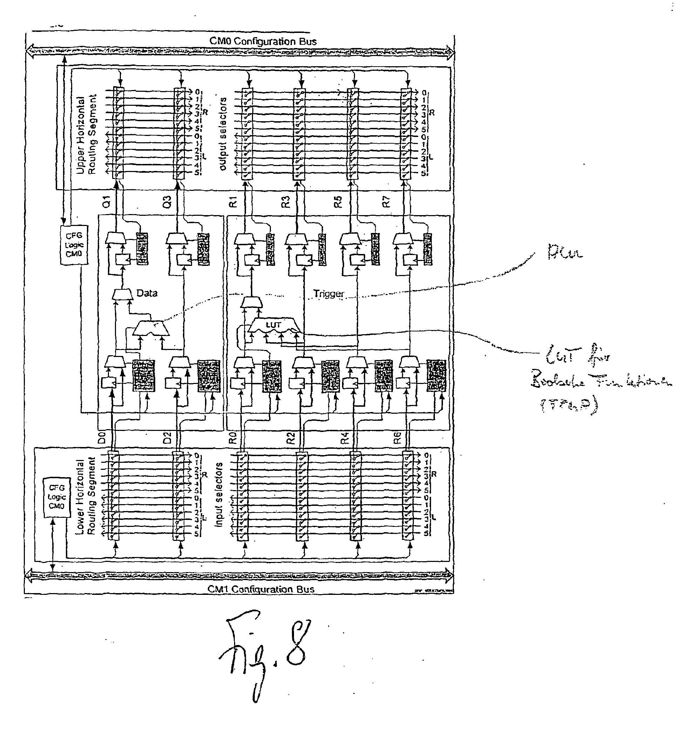

Fig. 8 eine weitere Detailansicht eines Rückwärtsregisters im Konfigurationsbus mit Nachschautabelle für die Implementierung boolscher Verknüpfungen von Triggervektorbits

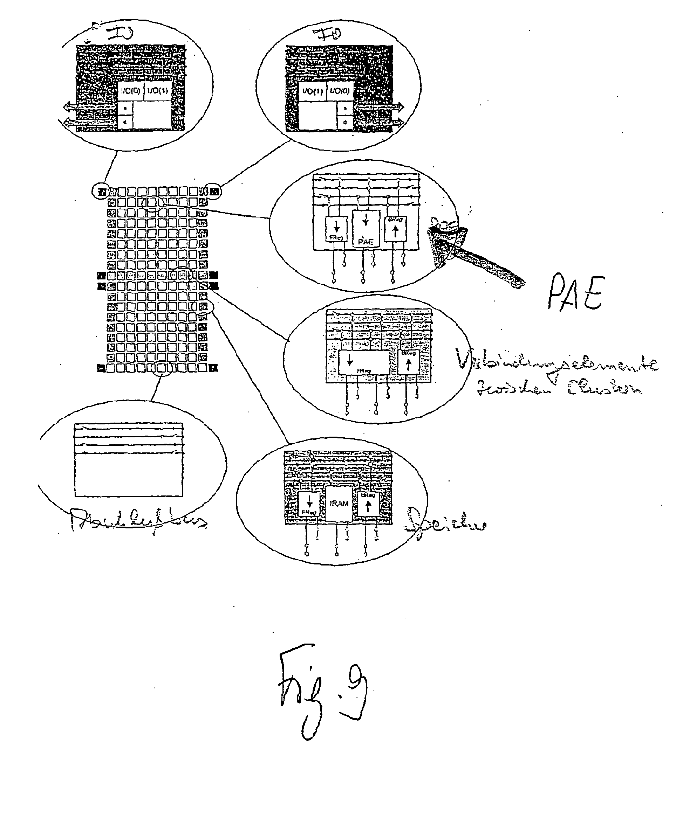

Fig. 9 weitere Prozessordetails insbesondere der Busse
Fig. 10 unsynchronisierte I/O Schaltung mit zwei Bussen
Fig. 11 synchronisierte I/O Schaltung mit zwei Bussen
Nach Fig.1 umfaßt ein allgemein mit 1 bezeichneter Prozessor 1, der eine als XPP (xtreme processing platform) bezeichenbare Einheit bilden kann, zwei Felder oder Cluster
   - einer Anzahl von arithmetischen Logikzellen (ALU-PAEs=arithmetic logic unit processing array element),
   - Speicherzellen (RAM-PAEs= Random acces memory processing array element)
   - mehreren, dargestellt vier Eingangs-/Ausgangszellen (E/A-Elemente, Input-output-processing aray element),
   - ein durch jedes Feld verlaufendes Bussystem, und
   - einen Konfigurationsmanager, der dem Feld zugeordnet ist,
      wobei diese Elemente zusammen als Cluster eine Einheit bilden, die für sich in der Lage ist, Daten zu verarbeiten und zwar als rekonfigurierbare Einheit
      und wobei den beiden Konfigurationsmanagern (CM) der Cluster ein übergeordneter Konfigurationsmanager (SCM) zugeordnet ist, um so ein Übercluster bzw. die XPP zu bilden, wobei erwähnt sei, daß es insbesondere unter Ausnutzung baumartiger Hierarchiestrukturen möglich ist, mehr als zwei Felder von Prozessorelementen zusammenarbeiten zu lassen; so kann ein übergeordneter Konfigurationsmanager mehr als nur zwei Konfigurationsmanagern (CM) übergeordnet sein, welche ihrerseits jeweils nur einem einzelnen PAE-Cluster zugeordnet sind, und/oder es kann vorgesehen sein, daß eine mehrstufige Konfigurationsmahager-Hierarchie aufgebaut list, worin ersten, eigentlich dem Cluster zugeordneten Konfigurationsmanagern (CM) ein Konfigurationsmanager mittlerer Ebene zugeordnet ist und diese wiederum einer oder mehreren Hierarchieebenen unterstehen.

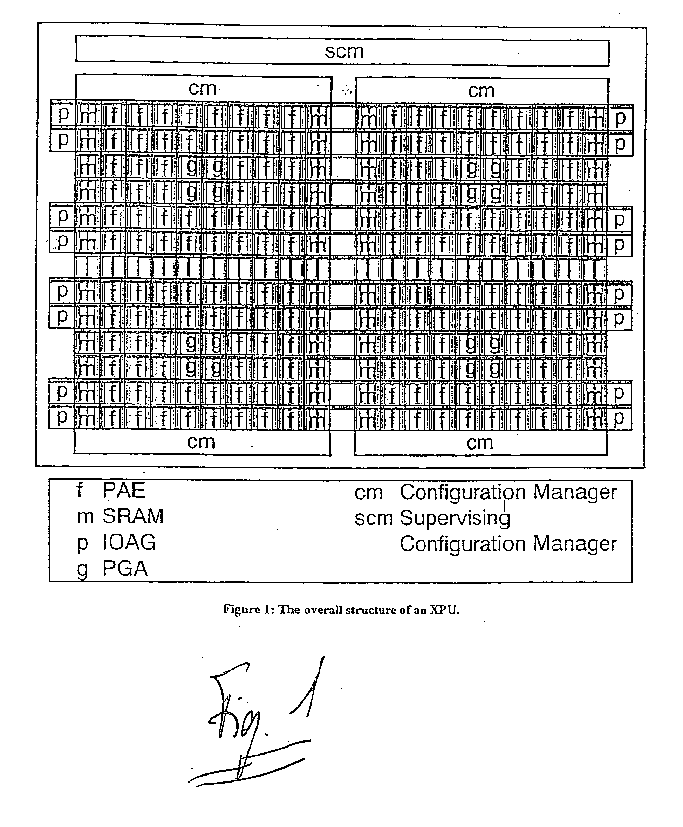

Fig. 1 gibt dabei die Anordnung der Zellen zueinander in einer zweidimensionalen Matrix und deren relative Größe näherungsweise zumindest insofern korrekt wieder, als daß die einzelnen Zellen sehr regelmäßig angeordnet sind und insbesondere die PAEs, also die speichernden und arithmetischen Logikzellen näherungsweise die gleiche Größe besitzen, was es erlaubt, bei der allgemein rechteckigen und/oder regulären Zellstruktur mit annähernd gleicher Anbindung an das Bussystem eine Kachelung vorzunehmen; die gezeigte Kachelung ist dabei aber insbesondere insofern willkürlich hinsichtlich der Anordnung von Speichern und Arithmetikeinheiten zueinander, als daß andere Anordnungen, auch unter Miteinbeziehung der I/O-Zellen und/oder unter Verwendung noch anderer Elemente problemfrei möglich sind, und ohne weiteres an eine gewünschte spezielle Rechenaufgabe anpaßbar sind. Die gezeigte Darstellung ist auch insofern beispielhaft, als statt einer zweidimensionalen Matrix auch eine dreidimensionale Anordnung von Einzelzellen im Raum möglich ist, sofern die Herstellungstechnik der verwendeten Halbleitertechnologie dies erlaubt.

Eine einzelne PAE umfaßt nun eine Vielzahl von Ein- und Ausgängen. Dabei ist die einzelne PAE einerseits mit Datenein-und Ausgängen (A,B,C) versehen und andererseits mit Steuer- bzw. Kontrollein- und ausgängen (U,V,W). Wie aus Fig. 1 ersichtlich, sind die PAEs in horizontalen Reihen angeordnet, wobei die Zellen untereinander über ein Bussystem miteinander verbunden sind; diese horizontalen Bussystem sind in der Feldmitte verbunden mit den darüber bzw. darunter liegenden PAEs und zwar im gezeigten bevorzugten Beispiel nach oben und unten nur mit diesen. Damit erfolgt der Transfer von Daten und Statussignalen (d.h. Steuersignalen) nach oben und unten durch die PAEs hindurch und zwar bevorzugt wie dargestellt in Fig. 1 unabhängig davon, um welche Art von PAEs es sich handelt, also unabhängig davon, ob es sich im vorliegenden Beispiel um eine RAM-PAE oder eine ALU-PAE handelt; es sind demnach alle Sorten von PAEs bevorzugt auf die gleiche Weise an das Bussystem angeschlossen und intern entsprechend verschaltet. Anders als dargestellt, wäre es prinzipiell sogar möglich, auch die E/A-Zellen zur Verbindung übereinander liegender Buslinien auszugestalten, was vorliegend allerdings unterblieben ist.

Die PAEs dienen somit der Weiterleitung von Daten, also zu verarbeitende sowie Steuer- bzw. Kontrollflußdaten in vertikaler Richtung. Die PAEs sind dabei so ausgebildet, daß diese Weiterleitung unter Datenveränderung oder unverändert erfolgt.

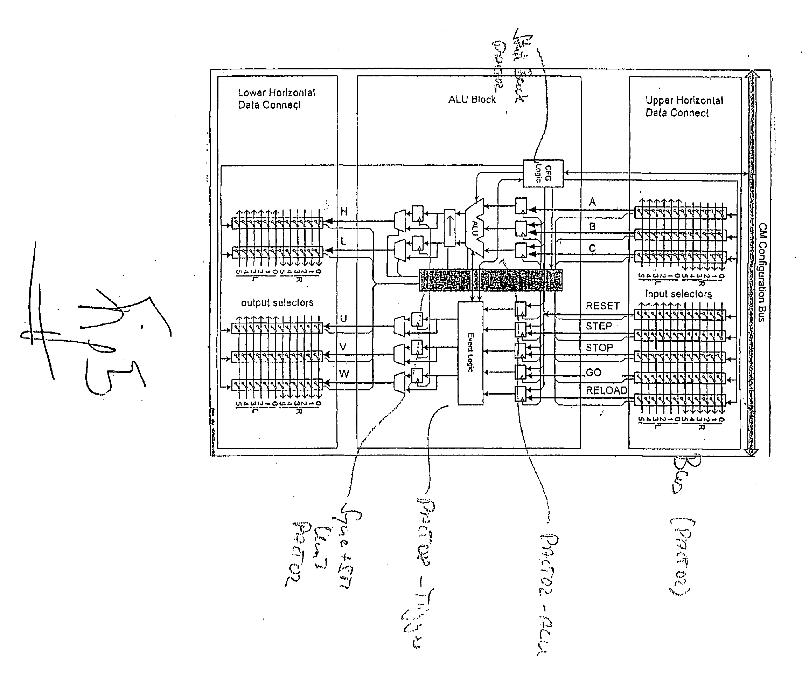

Die Datenveränderung kann zunächst in der eigentlichen Funktionseinheit der PAE erfolgen, z.B. wenn diese als arithmetische Logikeinheit ausgestattet ist und Daten in der Arithmetikeinheit verknüpft werden; um sicherzustellen, daß Daten hinreichend schnell bereitgestellt werden, um in der Zelle verknüpft zu werden und eine optimale Ausnutzung der Zelltaktung zu bewirken, sind drei Leitungen A,B,C mit der Bitbreite, die in der Zelle verarbeitet werden kann, an die Zelle geführt, vgl. Fig. 5. Dabei ist insbesondere auch eine bevorzugte additive Eingangsverknüpfung möglich, was es erlaubt, mit der Zelle Ergebnisse Operationen der Art (A+B)*C zeit- und platzeffizient zu bestimmen. Wenn keine Datenveränderung erforderlich ist, können die Daten an der Funktionseinheit vorbeigeleitet werden. So können z.B. Daten, die in einer Reihe weiter unten benötigt werden, dorthin durchgeleitet werden, ohne einer Veränderung in der PAE unterworfen zu werden. Es sei erwähnt, daß bei der simultanen Zuleitung von z.B. drei Datenwörtern entsprechend drei Eingänge A, B, C diese unterschiedlich weitergeleitet werden können. So ist es z.B. möglich, nur das Datenwort auf Leitung C unverändert weiterzuleiten, während A und B in der ALU miteinander verknüpft werden, z.B. durch Division A/B. Alternativ können auch zwei Datenworte an der ALU vorbeigeleitet werden, während ein Datenwort in der ALU z.B. mit einer Konstanten oder einem dort zwischengespeicherten anderen Wert verknüpft wird. Die Übertragbarkeit auf andere Datenwortmengen, die simultan der PAE zugeleitet werden, ist offensichtlich, d.h. es können auf Wunsch auch z.B. mehr als drei Datenworte an die PAE geführt sein; das einzelne Wort hat dabei die prozessorspezifische Bitbreite, vorliegend z.B. 32 Bit.
Beliebige Eingänge und/oder Ausgänge von PAEs können mit Konstanten von der Konfigurationseinheit (CT / CM) konfiguriert werden. Dabei können Konstante während des gesamten Betriebs einer Konfiguration unverändert konstant bleiben oder während des Betriebs d.h. der Ausführung einer Konfiguration von neuen Daten der Konfigurationseinheit (CT/CM) und/oder anderer Quellen wie z.B. PAEs überschrieben werden.

Auch ist einsichtig, daß anders als bei PAEs mit ALUs etwa in RAM-PAEs statt einer Verknüpfung aller oder eines Teils der Daten eine vollständige oder partielle Speicherung und/oder eine vollständige oder partielle Weiterleitung erfolgen kann.

Die Weiterleitung der Daten kann des weiteren unter Umgehung der eigentlich datenverändernden PAE-Kern-Einheit wie der ALU dergestalt erfolgen, daß dennoch eine Veränderung der Daten vor bzw. während der Weiterleitung erfolgt. Dies kann durch Veränderung der Daten unter Heranziehung von Nachschautabellen und anderen Verknüpfungseinheiten geschehen, z.B. Einheiten, die die eintreffenden Datenworte der Größe nach sortieren. Diese Einheiten sind bevorzugt zwischen die Busankopplung und den Eintritt in die PAE-Kern-Einheit angeordnet und in ihrer Funktion konfigurierbar, wodurch insesondere konfigurierbar ist, ob die Daten unverändert weitergeleitet werden oder nicht; wenn sie nicht unverändert, sondern verändert weitergeleitet werden, ist konfiguriert, wie innerhalb der gegebenen Möglichkeiten die Veränderung erfolgt. Besonders wichtig ist dabei für die Statussignalweiterleitung das vorsehen von Nachschautabellen, da mit diesen im Ansprechen auf vorbestimmte Eingangssignale ohne weiteres vorgegebene Ausgangssignale erzeugbar sind.

Weiter kann die Datenweiterleitung auch unveränderter Daten konfigurierbar sofort oder registerverzögert erfolgen. Die dargestellte einzelne PAE hat zu diesem Zweck je ein konfigurierbar zuschaltbares Vorwärts- und ein konfigurierbar zuschaltbares Rückwärtsregister für die zu verarbeitenden Daten und je ein konfigurierbar zuschaltbares Vorwärts- und ein konfigurierbar zuschaltbares Rückwärtsregister für Steuerdaten, d.h. Triggervektoren bzw.Statussignale und/oder Kontrollflußdaten; es sei darauf hingewiesen, daß Register mit erhöhter (Zwischenspeicher-)Tiefe insbesondere als FIFO-Register vorsehbar wären, etwa um Daten mehrtaktig zwischenzuspeichern. Den jeweiligen Registern ist ein konfigurierbarer Multiplexer zugeordnet, mit welchem das jeweilige Register wahlweise in den Datenweg geschaltet werden kann oder aus ihm entfernt. Auch sind die Multiplexer dazu konfigurierbar, Ergebnisse aus der Zelle wie erwünscht und erforderlich auf die Busse zu schalten. So können z.B. das obere und untere Bitwort, das bei einer Multiplikation erhalten wird, ausgegeben werden (H,L) und/oder es wird nur ein Ergebnisdatenwort (H) ausgegeben und ein Datenwort (A) weitergeleitet und auf den Bus ausgegeben, wobei sogar eine gewünschte Vertauschung (A<->H) konfiguriert werden kann. Damit ist eine PAE im vorliegenden Prozessormodell, und dies sei in seiner Bedeutung herausgestellt, charakterisiert durch eine Struktur, die eine Zentral-Funktionalität besitzt wie eine ALU, ein RAM und/oder z.B. auch ein FPGA und die weiter Datenweiterleitungsfunktionalität besitzt, wobei sie bevorzugt eine Vorwärts- und/oder Rückwärtsregisterdatenweiterleitungsfunktionalität besitzen kann, also dann aus drei Basismodulen, nämlich dem Zentralfunktionalitätsmodul wie FPGA, ALU, RAM und den zwei (Vorwärts- /Rückwärts-) Registerdatenweiterleitungsfunktionalitätmodulen besteht, wobei diese letzteren Zusatzfunktionen implementieren können. Zentralfunktionalität bedeutet dabei nicht räumliche Zentral-funktionalität, sondern Funktionalität im Sinne von Abstellen auf die zentrale Bedeutung und Wirkung der jeweiligen PAE. Die Zusatzfunktionen, die durch die Registerdatenweiterleitungsfunktionalitätmodule implementiert sind, umfassen insbesondere bevorzugt im Vorwärtsregister für den Datenfluß Kontrolloperationen wie das Multiplexen oder Demultiplexen sowie das Kopieren und/oder andere Manipulieren von Daten; im Rückwärtsregister wird bevorzugt implementiert eine ALU-Funktionalität für den Datenfluß und/oder eine Boolsche Verknüpfung von Eventsignalen, d.h. Triggersignalen. Somit besteht die PAE aus Modulen zur Manipulation von Datenströmen, zur operativen Verknüpfung und/oder Generierung von Datenpaketen sowie aus der Verarbeitung durch zumeist logische Verknüpfung und Generierung von Eventpaketen.

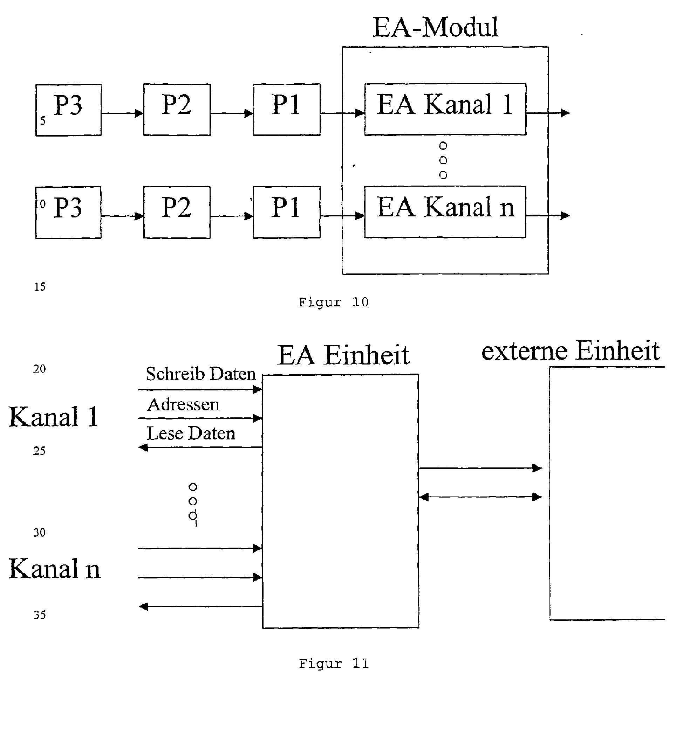

Die Ein-Ausgabemodule sind in ihrer Struktur gleichfalls in besonderer Weise an die Anforderungen der Datenverarbeitungsaufgabe angepaßt. Dazu ist jedes der Ein-Ausgabemodule mit mehreren Kanälen versehen, die unabhängig voneinander im sog. PORT-Modus (Fig. 10) arbeiten können oder in Synchronisation zueinander im sog. RAM-Modus (Fig. 11) arbeiten können. Jedes E/A-Modul kann dabei von mehreren Algorithmen unter Verwendung mehrerer Algorithmen gleichzeitig verwendet werden, wozu auch Sortieralgorithmen herangezogen werden können.

Mit anderen Worten arbeitet im Speicher-(RAM)-Modus (Fig. 11) das Ein/Ausgabemodul (I/O Schnittstelle) als Schnittstelle zu externem Speicher. Es werden dabei Schreibedaten und Adressdaten eines jeden Kanals synchronisiert, d.h. erst wenn beide Datenpakete vorhanden sind, wird ein externer Schreibvorgang gestartet. Im Lesemodus sortiert die EA Einheit von extern gesendete Pakete wieder an die internen Kanäle. Die Umschaltung zwischen Schreib- und Lesemodus kann z.B. per Konfiguration oder z.B. durch Signale erfolgen.

## Patentansprüche

1. Logikzellenanordnung (XPU) mit einer Anzahl Logikzellen (f, m, p, g) und einem segmentierten Bussystem für die Logikzellenkommunikation,
**dadurch gekennzeichnet, daß**
das Bussystem unterschiedliche Segmentlinien mit kürzeren und längeren Segmenten zur Verbindung zweier Punkte umfaßt, um die Anzahl zu durchlaufender Buselemente bei auseinander beabstandeten Kommunikationsstart- und Endpunkten gering halten zu können.

2. Logikzellenanordnung (XPU) nach dem vorhergehenden Anspruch, **dadurch gekennzeichnet, daß** die Segmentlinien jeweils aus einer Mehrzahl paralleler Leitungen gebildet sind, deren Anzahl durch die Bus-Breite und/oder das Busprotokoll bestimmt ist.

3. Logikzellenanordnung (XPU) nach einem der vorhergehenden Ansprüche, **dadurch gekennzeichnet, daß** datenverändernden Logikzellen (f, m, p, g) drei der für die verarbeitete Bitbreite erforderlichen Leitungsbündel (A, B, C) als Datenzuführungsleitungen zugeführt sind.

4. Logikzellenanordnung (XPU) nach einem der vorhergehenden Ansprüche, **dadurch gekennzeichnet, daß** von datenverändernde Logikzellen (f, m, p, g) zwei der für die verarbeitete Bitbreite erforderlichen Leitungsbündel für Daten (H, L) weggeführt sind, insbesondere mit einem Leitungsbündel für höherwertige (H) und einem Leitungsbündel für niederwertigere (L) Bits.

5. Logikzellenanordnung (XPU) nach einem der vorhergehenden Ansprüche, **dadurch gekennzeichnet, daß** bei rekonfigurierbaren Logikzellen (f, m, p, g) an deren Steuereingänge Leitungsbündel geführt sind, die derart angeordnet sind, daß wenigstens Signale in die Zelle übertragbar sind, die alternativ wenigstens eine Art der Aktivierung (Step, Stop, Go), ein Zurücksetzen (Reset) und ein Rekonfigurieren (Reload) bewirken können.

6. Logikzellenanordnung (XPU) nach einem der vorhergehenden Ansprüche,
**dadurch gekennzeichnet, daß**
das Bussystem Segmente zur Verbindung der Logikzellen (f, m, p, g)
- untereinander und/oder mit
- internen und/oder externen, die Logikzellen (f, m, p, g)
- konfigurierenden und/oder rekonfigurierenden Einheiten, und/oder
- I/O-Schnittstellen und/oder zur Logikzellenanordnung (XPU) externen Datenspeichern
umfaßt.

7. Logikzellenanordnung (XPU) nach einem der vorhergehenden Ansprüche, **dadurch gekennzeichnet, daß**
das Busystem neben Leitungen weiter Leitungszwischenelemente umfaßt,
bevorzugt zumindest eines der Buselemente
verbindungs-Schalter,
Multiplexer,
Register (FREG, BREG),
bevorzugt algebraisches verknüpfendes Register,
bevorzugt addierendes und/oder multiplizierendes Register,
bevorzugt nur zwei Operanden algebraisches verknüpfendes Register
Logikverknüpfungsschaltungen boolscher Art (Event LUT),
bevorzugt Nachschautabellen, und/oder Leitungstreiber.

8. Logikzellenanordnung (XPU) nach dem vorhergehenden Anspruch, worin Logikverknüpfungsschaltungen als Buselemente vorgesehen sind, **dadurch gekennzeichnet, daß** die Logikverknüpfungsschaltungen von einer Logikzellenrekonfigurierungseinheit, bevorzugt einer Konfigurationsmanagingeinheit (CM) und/oder einer Logikzelle (f, m, p, g) beschreibbar ist.

9. Logikzellenanordnung (XPU) nach einem der vorhergehenden Ansprüche, **dadurch gekennzeichnet, daß** Übergangsmöglichkeiten von einem Segment einer ersten Segmentlinie auf ein Segment einer zweiten Segmentlinie vorgesehen sind.

10. Logikzellenanordnung (XPU) nach einem der vorhergehenden Ansprüche, **dadurch gekennzeichnet, daß** das Bussystem eine Vielzahl von parallelen Segmentlinien umfaßt, wobei mehrere parallele Segmentlinien mit längeren Segmenten vorgesehen sind.

11. Logikzellenanordnung (XPU) nach dem vorhergehenden Anspruch, **dadurch gekennzeichnet, daß**
für unterschiedliche der Mehrzahl an parallelen Segmentlinien mit längeren Segmenten
die Segmentlinienenden und/oder Leitungszwischenelemente in den Segmentlinien
in Busrichtung versetzt gegeneinander angeordnet sind, bevorzugt um jeweils mindestens eine Logikzeleneinheit versetzt.

12. Logikzellenanordnung (XPU) nach dem vorhergehenden Anspruch, **dadurch gekennzeichnet, daß** bei wenigstens drei Segmentlinien mit längeren Segmenten für wenigstens zwei Segmentlinien bei vorgegebenen Stellen Segmentlinienwechselkreise, insbesondere Multiplexer, als Leitungszwischenelemente vorgesehen sind.

13. Logikzellenanordnung (XPU) nach dem vorhergehenden Anspruch, **dadurch gekennzeichnet, daß** die Segmentlinienwechselkreise für den Wechsel von einer ersten auf eine zweite Segmentlinie an einer ersten Stelle und die Segmentlinienwechselkreise für den Wechsel von einer zweiten auf eine dritte Segmentlinie an einer zweiten Stelle vorgesehen sind.

14. Logikzellenanordnung (XPU) nach dem vorhergehenden Anspruch, **dadurch gekennzeichnet, daß** zumindest ein Segmentlinienwechselmultiplexer vorgesehen ist, der den wahlweisen Übergang von einer Segmentlinie auf wenigstens eine Vielzahl von Segmentlinien ermöglicht.

15. Logikzellenanordnung (XPU) nach dem vorhergehenden Anspruch, **dadurch gekennzeichnet, daß** getrennte Busanordnungen für entgegengesetzte Laufrichtungen ausgebildet sind, wobei für wenigstens eine Laufrichtung unterschiedliche Segmentlinien mit kürzeren und längeren Segmenten vorgesehen sind.

16. Logikzellenanordnung (XPU) nach dem vorhergehenden Anspruch, **dadurch gekennzeichnet, daß** bei getrennten Segmentlinien für beide Laufrichtungen und für wenigstens eine Laufrichtung Register vorgesehen sind.

17. Logikzellenanordnung (XPU) nach dem vorhergehenden Anspruch, **dadurch gekennzeichnet, daß** Register in rückwärtsgeführten Bussystemen vorgesehen sind, d.h. Bussystemen, mit denen Signale von einem Elementausgang zu einem Elementeingang zurückgeführt werden können.

18. Logikzellenanordnung (XPU) nach einem der vorhergehenden Ansprüche, **dadurch gekennzeichnet, daß** wahlweise zuschaltbare Register zwischen zumindest zwei Segmenten wenigstens einer Segmentlinie vorgesehen sind.

19. Logikzellenanordnung (XPU) nach dem vorhergehenden Anspruch, **dadurch gekennzeichnet, daß** wenigstens ein wahlweise zuschaltbares Register in einem vorwärtsgeführten Register vorgesehen ist.

20. Logikzellenanordnung (XPU) nach dem vorhergehenden Anspruch, **dadurch gekennzeichnet**, worin ein Mittel (CM) vorgesehen ist, um das Register bei Ausführung eines Programmes nach Wahl des Compilers zuzuschalten.

21. Logikzellenanordnung (XPU) nach einem der vorhergehenden Ansprüche, **dadurch gekennzeichnet, daß** ein erstes Bussystem für die Übertragung zu bearbeitender Daten und ein zweites Bussystem für die Übertragung von Status-und/oder Kontroll-bzw. Steuerinformation (Configuration Bus) vorgesehen ist.

22. Logikzellenanordnung (XPU) nach dem vorhergehenden Anspruch, **dadurch gekennzeichnet, daß** wenigstens bei einem der Bussystem unterschiedliche Segmentlinien mit parallelen kürzeren und längeren Segmenten zur Verbindung zweier Punkte vorgesehen sind, um bei auseinander beabstandeten Logikzellen (f, m, p, g) die Anzahl zu durchlaufender Buselemente gering halten zu können.

23. Logikzellenanordnung (XPU) nach einem der vorhergehenden Ansprüche, **dadurch gekennzeichnet, daß** wenigstens eine Reihe mit wengistens drei Logikzellen (f, m, p, g) vorgesehen ist und die längeren Segmente an wenigstens einer Logikzelle (f, m, p, g) vorbeigeführt sind.

24. Logikzellenanordnung (XPU) nach einem der vorhergehenden Ansprüche, **dadurch gekennzeichnet, daß** wenigstens eine Reihe mit mehr als drei Logikzellen (f, m, p, g) vorgesehen ist und die längsten Segmente an mehr als einer Logikzelle (f, m, p, g) vorbeigeführt sind.

25. Logikzellenanordung (XPU) nach einem der vorhergehenden Ansprüche, **dadurch gekennzeichnet, daß** die Logikzellen (f, m, p, g) ausgewählt sind aus, umfassen und/oder bilden Rechenwerke, DPGAs, Kress-Arrays, systolische Prozessoren und RAW-Machines; digitale Signalprozessoren (DSPs), die mehr als ein Rechenwerk besitzen, konfigurierbare (programmierbare) Logikzellen (f, m, p, g) oder andere Cores und/oder PAEs, ALU, Eingabe- / Ausgabefunktionen (I/O) und Speichermanagementeinheiten (I/O), Speicher.

## Claims

1. Logic cell arrangement (XPU) with a number of logic cells (f, m, p, g) and a segmented bus system for logic cell communication, **characterised in that** the bus system comprises different segment lines with shorter and longer segments for connecting two points so that the number of bus elements to be passed through can be kept low when the communication start and end points are at a distance from one another.

2. Logic cell arrangement (XPU) according to the preceding claim, **characterised in that** the segment lines are each formed from a plurality of parallel lines, the number of which is determined by the bus width and/or the bus protocol.

3. Logic cell arrangement (XPU) according to any one of the preceding claims, **characterised in that** data-modifying logic cells (f, m, p; g) are introduced, as data introduction lines, into three of the line bundles (A, B, C) required for the processed bit width.

4. Logic cell arrangement (XPU) according to any one of the preceding claims, **characterised in that** two of the line bundles required for the processed bit width, for data (H, L), are led away from the data-modifying logic cells (f, m, p, g), in particular with a line bundle for higher-value bits (H) and a line bundle for lower-value bits (L).

5. Logic cell arrangement (XPU) according to any one of the preceding claims, **characterised in that** in the case of logic cells (f, m, p, g) which can be reconfigured, line bundles are guided to the control inputs thereof and are arranged in such a way that at least signals which can alternatively effect at least one type of activation (Step, Stop, Go), a reset (Reset) and a reconfiguration (Reload) can be conveyed into the cell.

6. Logic cell arrangement (XPU) according to any one of the preceding claims, **characterised in that** the bus system comprises segments for connecting the logic cells (f, m, p, g)
- to one another and/or
- to internal and/or external units which configure and/or reconfigure the logic cells (f, m, p, g)
- and/or to I/O interfaces and/or
- to data storage units external to the logic cell arrangement (XPU).

7. Logic cell arrangement (XPU) according to any one of the preceding claims, **characterised in that** in addition to lines the bus system further comprises inter-line elements,
- preferably at least one of the following bus elements: a position grouping key, multiplexers, a register (FREG, BREG);
- preferably an algebraic linking register,
- preferably an adding and/or multiplying register,
- preferably only two operand algebraic linking registers
- boolean logic circuits (Event LUT),
- preferably lookup tables and/or line drivers.

8. Logic cell arrangement (XPU) according to any one of the preceding claims, in which logic circuits are provided as bus elements, **characterised in that** the logic circuits are describable by a logic cell reconfiguration unit, preferably a configuration managing unit (CM) and/or a logic cell (f, m, p, g).

9. Logic cell arrangement (XPU) according to the preceding claim, **characterised in that** transition options from a segment of a first segment line to a segment of a second segment line are provided.

10. Logic cell arrangement (XPU) according to any one of the preceding claims, **characterised in that** the bus system comprises a plurality of parallel segment lines, a plurality of parallel segment lines with longer segments being provided.

11. Logic cell arrangement (XPU) according to the preceding claim, **characterised in that** for different ones of the plurality of parallel segment lines with longer segments, the segment line ends and/or inter-line elements in the segment lines are arranged offset from one another in the bus direction, preferably offset by at least one logic cell unit in each case.

12. Logic cell arrangement (XPU) according to the preceding claim, **characterised in that** with at least three segment lines with longer segments, segment line exchange circuits, in particular multiplexes, are provided as inter-line elements in predetermined positions for at least two segment lines.

13. Logic cell arrangement (XPU) according to the preceding claim, **characterised in that** the segment line exchange circuit for the change from a first to a second segment line is provided in a first position and the segment line exchange circuit for the change from a second to a third segment line is provided in a second position.

14. Logic cell arrangement (XPU) according to the preceding claim, **characterised in that** at least one segment line exchange Multiplexer is provided and allows the selective transition from one segment line to at least a plurality of segment lines.

15. Logic cell arrangement (XPU) according to the preceding claim, **characterised in that** separate bus arrangements are formed for opposite running directions, different segment lines with shorter and longer segments being provided for at least one running direction.

16. Logic cell arrangement (XPU) according to the preceding claim, **characterised in that** with divided segment lines registers are provided for the two running directions and for at least one running direction.

17. Logic cell arrangement (XPU) according to the preceding claim, **characterised in that** registers are provided in backward bus systems, i.e. bus systems with which signals can be led back from an element output to an element input.

18. Logic cell arrangement (XPU) according to any one of the preceding claims, **characterised in that** registers which can be selectively added-on are provided between at least two segments of at least one segment line.

19. Logic cell arrangement (XPU) according to the preceding claim, **characterised in that** at least one register which can bus selectively added-on is provided in a forward register.

20. Logic cell arrangement (XPU) according to the preceding claim, **characterised in that** a means (CM) is provided for adding on the register in accordance with a election by the compiler when executing a program.

21. Logic cell arrangement (XPU) according to any one of the preceding claims, **characterised in that** a first bus system is provided for the transmission of data to be processed and a second bus system (Configuration Bus) is provided for the transmission of status information and/or control or regulation information.

22. Logic cell arrangement (XPU) according to the preceding claim, **characterised in that** at least for one of the bus systems, different segment lines with parallel shorter and longer segments for connecting two points are provided so that the number of bus elements to be passed through can be kept low when the logic cells (f, m, p, g) are at a distance from one another.

23. Logic cell arrangement (XPU) according to any one of the preceding claims, **characterised in that** at least one series is provided with at least three logic cells (f, m, p, g) and the longer segments are guided past at least one logic cell (f, m, p, g).

24. Logic cell arrangement (XPU) according to any one of the preceding claims, **characterised in that** at least one series is provided with more than three logic cells (f, m, p, g) and the longest segments are guided past more than one logic cell (f, m, p, g).

25. Logic cell arrangement (XPU) according to any one of the preceding claims, **characterised in that** the logic cells (f, m, p, g) are selected from, comprise and/or form arithmetic units, DPGAs, Kress Arrays, systolic processors and RAW machines; digital signal processors (DSPs) comprising more than one arithmetic unit, configurable (programmable) logic cells (f, m, p, g) or other cores and/or PAEs, ALUs, input/output functions (I/O) and memory management units (I/O), and storage units.

## Revendications

1. Ensemble de cellules logiques (XPU) comprenant un certain nombre de cellules logiques (f, m, p, g) et un système de bus segmenté pour la communication des cellules logiques,
**caractérisé en ce que**
le système de bus comprend différentes lignes de segments avec des segments plus courts et plus longs destinés à relier deux points pour pouvoir minimiser le nombre d'éléments de bus à parcourir en cas de points de départ et d'arrivée de communication distants l'un de l'autre.

2. Ensemble de cellules logiques (XPU) selon la revendication précédente, **caractérisé en ce que** les lignes de segments sont chaque fois formées d'une pluralité de lignes parallèles dont le nombre est déterminé par la largeur de bus et/ou le protocole de bus.

3. Ensemble de cellules logiques (XPU) selon l'une des revendications précédentes, **caractérisé en ce que** trois des faisceaux de lignes (A, B, C) nécessaires pour le nombre de bits traité sont amenés en tant que lignes d'amenée de données à des cellules logiques modificatrices de données (f, m, p, g).

4. Ensemble de cellules logiques (XPU) selon l'une des revendications précédentes, **caractérisé en ce que** deux des faisceaux de lignes de données (H, L) nécessaires pour le nombre de bits traité repartent de cellules logiques modificatrices de données (f, m, p, g), en particulier un faisceau de lignes pour les bits de poids fort (H) et un faisceau de lignes pour les bits de poids faible (L).

5. Ensemble de cellules logiques (XPU) selon l'une des revendications précédentes, **caractérisé en ce qu'**en cas de cellules logiques reconfigurables (f, m, p, g), des faisceaux de lignes qui sont disposés de façon qu'il soit possible de transmettre à la cellule au moins des signaux qui, au choix, peuvent provoquer au moins un mode d'activation (Step, Stop, Go), une réinitialisation (Reset) et une reconfiguration (Reload) sont amenés à leurs entrées de commande.

6. Ensemble de cellules logiques (XPU) selon l'une des revendications précédentes,
**caractérisé en ce que**
le système de bus comprend des segments pour relier les cellules logiques (f, m, p, g)
- entre elles et/ou à
- des unités internes et/ou externes capables de
- configurer et/ou reconfigurer les cellules logiques (f, m, p, g) et/ou
- des interfaces E/S et/ou des mémoires de données externes à l'ensemble de cellules logiques (XPU).

7. Ensemble de cellules logiques (XPU) selon l'une des revendications précédentes,
**caractérisé en ce que**
le système de bus comprend, en plus de lignes, des éléments intermédiaires de lignes,
de préférence au moins l'un des éléments de bus
commutateur de connexion,
multiplexeur,
registre (FREG, BREG),
de préférence registre de combinaison algébrique,
de préférence registre additionneur et/ou multiplicateur,
de préférence registre combinant algébriquement seulement deux
opérandes,
circuits de combinaison logique de type booléen (Event LUT),
de préférence tables de correspondance,
et/ou amplificateurs de ligne.

8. Ensemble de cellules logiques (XPU) selon l'une des revendications précédentes dans lequel des circuits de combinaison logique sont prévus comme éléments de bus, **caractérisé en ce que** les circuits de combinaison logique sont accessibles en écriture avec une unité de reconfiguration de cellules logiques, de préférence une unité de gestion de configuration (CM) et/ou une cellule logique (f, m, p, g).

9. Ensemble de cellules logiques (XPU) selon l'une des revendications précédentes, **caractérisé en ce qu'**il est prévu des possibilités de passage d'un segment d'une première ligne de segments à un segment d'une deuxième ligne de segments.

10. Ensemble de cellules logiques (XPU) selon l'une des revendications précédentes, **caractérisé en ce que** le système de bus comprend une pluralité de lignes de segments parallèles, plusieurs lignes de segments parallèles étant prévues avec des segments plus longs.

11. Ensemble de cellules logiques (XPU) selon la revendication précédente, **caractérisé en ce que**
pour différentes lignes de segments parallèles de la majorité de celles avec des segments plus longs
les extrémités de lignes de segments et/ou les éléments intermédiaires de lignes dans les lignes de segments
sont disposés en décalage les uns par rapport aux autres dans la direction du bus, de préférence décalés chaque fois au moins d'une unité de cellules logiques.

12. Ensemble de cellules logiques (XPU) selon la revendication précédente, **caractérisé en ce que** dans le cas d'au moins trois lignes de segments avec des segments plus longs, il est prévu pour au moins deux lignes de segments, à des positions prédéfinies, des circuits de changement de lignes de segments, en particulier des multiplexeurs, comme éléments intermédiaires de lignes.

13. Ensemble de cellules logiques (XPU) selon la revendication précédente, **caractérisé en ce que** les circuits de changement de lignes de segments pour le passage d'une première à une deuxième ligne de segments sont prévus à une première position et les circuits de changement de lignes de segments pour le passage d'une deuxième à une troisième ligne de segments à une deuxième position.

14. Ensemble de cellules logiques (XPU) selon la revendication précédente, **caractérisé en ce qu'**il est prévu au moins un multiplexeur de changement de lignes de segments qui permet le passage au choix d'une ligne de segments à au moins une pluralité de lignes de segments.

15. Ensemble de cellules logiques (XPU) selon la revendication précédente, **caractérisé en ce que** des systèmes de bus séparés pour des sens de marche opposés sont réalisés, différentes lignes de segments avec des segments plus courts et plus longs étant prévues pour au moins un sens de marche.

16. Ensemble de cellules logiques (XPU) selon la revendication précédente, **caractérisé en ce qu'**en cas de lignes de segments séparées, des registres sont prévus pour les deux sens de marche et pour au moins un sens de marche.

17. Ensemble de cellules logiques (XPU) selon la revendication précédente, **caractérisé en ce que** des registres sont prévus dans les systèmes de bus menés vers l'arrière, c'est-à-dire les systèmes de bus avec lesquels il est possible de ramener des signaux d'une sortie d'élément à une entrée d'élément.

18. Ensemble de cellules logiques (XPU) selon l'une des revendications précédentes, **caractérisé en ce que** des registres activables au choix sont prévus entre au moins deux segments d'au moins une ligne de segments.

19. Ensemble de cellules logiques (XPU) selon la revendication précédente, **caractérisé en ce qu'**au moins un registre activable au choix est prévu dans un registre mené vers l'avant.

20. Ensemble de cellules logiques (XPU) selon la revendication précédente, **caractérisé en ce qu'**il y est prévu un moyen (CM) pour activer le registre au choix du compilateur lors de l'exécution d'un programme.

21. Ensemble de cellules logiques (XPU) selon l'une des revendications précédentes, **caractérisé en ce qu'**il est prévu un premier système de bus pour la transmission de données à traiter et un deuxième système de bus pour la transmission d'informations d'état et/ou de contrôle ou de commande (Configuration Bus).

22. Ensemble de cellules logiques (XPU) selon la revendication précédente, **caractérisé en ce qu'**il est prévu au moins sur un des systèmes de bus différentes lignes de segments avec des segments parallèles plus courts et plus longs destinés à relier deux points pour pouvoir minimiser le nombre d'éléments de bus à parcourir dans le cas de cellules logiques (f, m, p, g) distantes l'une de l'autre.

23. Ensemble de cellules logiques (XPU) selon l'une des revendications précédentes, **caractérisé en ce qu'**il est prévu au moins une rangée d'au moins trois cellules logiques (f, m, p, g) et que les segments plus longs ne passent pas par au moins une cellule logique (f, m, p, g).

24. Ensemble de cellules logiques (XPU) selon l'une des revendications précédentes, **caractérisé en ce qu'**il est prévu au moins une rangée de plus de trois cellules logiques (f, m, p, g) et que les segments plus longs ne passent pas par plus d'une cellule logique (f, m, p, g).

25. Ensemble de cellules logiques (XPU) selon l'une des revendications précédentes, **caractérisé en ce que** les cellules logiques (f, m, p, g) sont sélectionnées parmi, comprennent et/ou forment des unités de calcul, des DPGA, des réseaux de Kress, des processeurs systoliques et des machines RAW ; des processeurs de signaux numériques (DSP) qui possèdent plus d'une unité de calcul, des cellules logiques (f, m, p, g) configurables (programmables) ou d'autres cores et/ou des PAE, ALU, fonctions d'entrée/sortie (E/S) et unités de gestion de mémoire (E/S), mémoires.
